(19) **Europäisches Patentamt**

**European Patent Office**

**Office européen des brevets**

(11) **EP 1 052 518 B1**

(12) **EUROPEAN PATENT SPECIFICATION**

(45) Date of publication and mention
of the grant of the patent:
**05.02.2003 Bulletin 2003/06**

(51) Int Cl.7: **G01R 31/02**

(21) Application number: **99830294.7**

(22) Date of filing: **13.05.1999**

(54) **A system for the complete diagnosis of a driver**

Einrichtung zur vollständigen Diagnose eines Treibers

Dispositif de diagnostique complet d'un circuit d'attaque

(84) Designated Contracting States:
**DE ES FR GB IT**

(43) Date of publication of application:
**15.11.2000 Bulletin 2000/46**

(73) Proprietors:
- **STMicroelectronics S.r.l.**
  **20041 Agrate Brianza (Milano) (IT)**
- **MAGNETI MARELLI POWERTRAIN S.p.A.**
  **10138 Torino (IT)**

(72) Inventors:
- **Milanesi, Andrea**
  **15052 Casalnoceto (Alessandria) (IT)**
- **Chicca, Stefania**
  **56019 Vecchiano (Pisa) (IT)**
- **Poletto, Vanni**
  **15033 Casale Monferrato (Alessandria) (IT)**
- **Giorgetta, Valerio**
  **14024 Moncucco Torinese (Asti) (IT)**
- **Sgatti, Stefano**
  **40026 Imola (Bologna) (IT)**
- **Vigna, Sergio**
  **10042 Nichelino (Torino) (IT)**

(74) Representative: **Quinterno, Giuseppe et al**
**Jacobacci & Partners S.p.A.,**
**Corso Regio Parco, 27**
**10152 Torino (IT)**

(56) References cited:
**EP-A- 0 810 444        WO-A-91/16637**
**US-A- 5 063 516        US-A- 5 111 123**
**US-A- 5 304 935        US-A- 5 623 254**

**Description**

The present invention relates to a system for the diagnosis of a driver as defined in the preamble of Claim 1.

In particular, it relates to a system for the complete diagnosis of the operating state of a driver of the type used in the automotive field in engine electronic control units for driving an actuator device associated with the engine itself.

In such units (ECU) a central processing unit, such as a microprocessor, controls the operation of the actuator devices associated with the engine via low power control signals. Each actuator device has an associated corresponding driver to raise the power of the control signals to a level sufficient to allow actuation of the actuator itself. A plurality of drivers can be formed in a single semiconductor integrated circuit.

For the correct operation of the engine, the processing unit of the control unit requires a complete analysis of the operating state of the drivers in their different operating phases, for the purpose of detecting possible anomalies (for example, short circuits to ground, short circuits to the battery, open circuit to load) which may temporarily occur, and take the necessary counter measures. For this reason there are provided diagnosis circuits associated with each driver and formed integrally on the same semiconductor component.

For communicating the results of the diagnosis processes to the microprocessor which supervises the control of the actuator devices, one signalling pin in the integrated semiconductor component is commonly reserved for each driver, on which pin at least one bit of serial information is transmitted. In diagnosis systems which use a single bit for the indication of anomalies (the bit assumes a logic high value or a logic low value depending on the logic convention used, when an anomaly is encountered) it is not possible to provide the microprocessor with further indications of the type of anomaly detected.

In general, more complex systems provide a description of the type of anomaly encountered by means of an associated code, and this description is stored internally within the integrated component, transmitted to the microprocessor as a serial word and reset on command of the microprocessor itself when it has been read. Resetting arranges the diagnosis circuit for subsequent ascertainment of the operating state of the driver. The code adopted envisages a number of available bits so as to be able to represent n separate combinations of which n-1 combinations are reserved for the description of anomalies and only one combination is reserved for coding the condition of "no anomaly detected".

A system for diagnosis of a driver is known from EP 0 810 444.

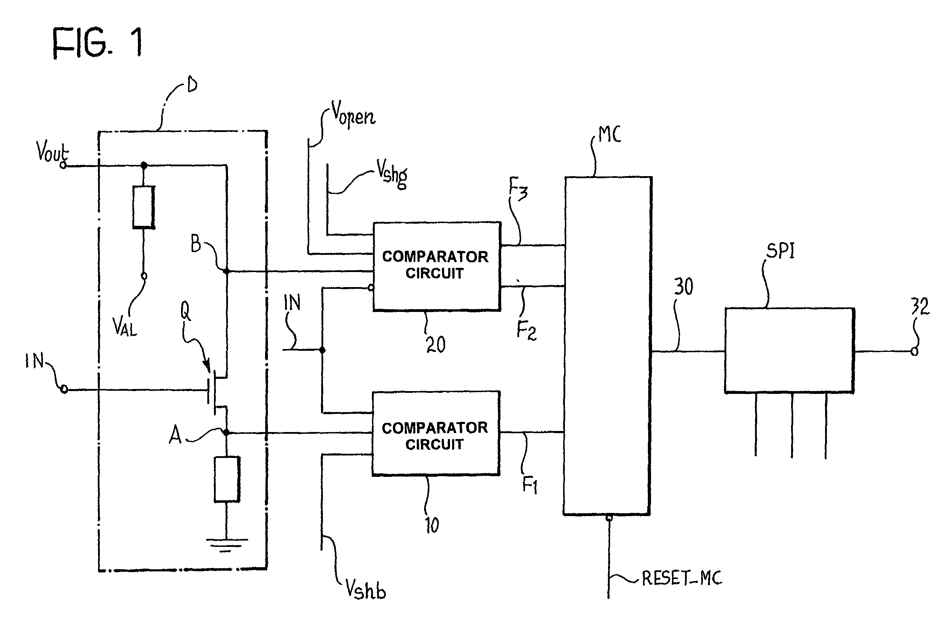

In order better to understand the operation of the arrangements adopted and to make their disadvantages apparent, a prior art diagnosis system is illustrated in Figure 1. The driver is of the so-called low-side type, supplied from a voltage supply source $V_{AL}$, and is generally indicated D, whilst the microprocessor control unit which provides the said driver with a logic control signal IN is not shown, nor is the actuator device which is controlled by the said driver via a driving signal $V_{out}$. The circuit D is controlled in one of two possible operating phases as a function of the state of conduction of an electronic switch Q such as a MOSFET transistor, driven at a control electrode by the logic signal IN.

A first node A and a second node B of the driver D are connected to the inputs of corresponding first and second comparator circuits, respectively indicated 10 and 20. Both circuits also receive at their inputs the logic control signal IN from the microprocessor. The first comparator circuit 10 also has an input short-circuit-to-battery reference voltage $V_{shb}$. The second comparator circuit 20 also receives an input short circuit to ground reference voltage $V_{shg}$ and an open circuit-to-load reference voltage $V_{open}$.

In a simple embodiment the comparator circuits 10 and 20 respectively include one and two threshold comparator circuits and are formed in such a way as to provide output logic diagnosis signals $F_1$, $F_2$, $F_3$ indicative of the presence/absence of the anomaly which they are responsible for recognising, in the specific case, respectively, short circuit to battery, short circuit to ground, and open circuit to load. The diagnosis signals $F_1$, $F_2$, $F_3$ are transmitted to a memory and coding circuit MC which outputs a coded word on a state bus 30, which represents the detected operating state.

The capacity of the state bus 30 is correlated to the number of anomalies which the system is able to detect. In the particular example, since it is desired to recognise the above listed anomalies, plus a condition of "no detected anomalies", only two bits are provided to convey this information.

The state bus 30 is connected to the input of a serial peripheral interface SPI arranged to receive at other inputs similar state buses from the memory and coding circuits corresponding to other diagnosis systems integrated on the same semiconductor component. This interface can be selected by the microprocessor of the control unit and can transmit the detected information to it in a synchronised manner via a signalling pin 32. The circuit MC is arranged to be reset by the microprocessor itself via the reset signal RESET_MC once transmission has taken place.

The microprocessor is programmed to perform a recognition procedure for detecting the presence of anomalies and their extinction, and to drive the actuator device conveniently as a function of the recognised operating state of the corresponding driver. Because the microprocessor does not know the operating phase of the individual drivers (for example ON, OFF, high impedance) in that the monitoring of such phases is usually delegated to an external time programming unit (TPU), it is important that it does not receive erroneous information about the presence/absence of anomalies.

A conventional diagnosis circuit is able to detect a given anomaly only in particular operating phases of the driver. For example, anomalies such as short circuit to battery in a driver of the type described can only be detected during an activation (ON) phase of the circuit, whilst anomalies such as a short circuit to ground or an open circuit to load condition can only be detected during a phase in which the circuit is not active (OFF).

This involves the disadvantage that each time the information relating to the code of an anomaly, stored in the memory and coding circuit MC, is reset after a reading by the microprocessor, this anomaly cannot be further detected if, simultaneously, the operating phase of the driver is changed, even if the anomaly is actually still present. In this case the operating state of the driver is identified by a "no anomaly detected" condition and, in a second instant, the microprocessor proceeds erroneously to recognise extinction of the previously occurred anomaly.

A second disadvantage of the known arrangements relates to the possibility of not detecting anomalies even during the operating phase of the driver in which they can be recognised. The implementation of the memory and coding circuit according to the prior art is such that, between two consecutive readings by the microprocessor of the control unit, only the first anomaly encountered after resetting of the information in the memory is detected and stored, ignoring all the subsequent anomalies and thereby causing an updating loss in the control unit.

The object of the present invention is to provide a system for diagnosis of a driver which does not have the above listed disadvantages. In particular, the system according to the invention has the object of providing a coding of the anomalies such as not to cause errors in recognition by the microprocessor, that is to say to provide a coding of "no anomaly detected" only if the system has ascertained this condition during each of the operating phases of the driver. That is to say the system must be able to distinguish the condition of "no detected anomaly in each operating phase" from a plurality of conditions of "no detected anomaly in the current operating phase".

A further object of the present invention is to provide a diagnosis system which is able to detect and code the last anomaly occurring in a series of concurrent anomalies, in such a way as to allow the control unit to perform a correct updating on the operating state of the driver under examination.

To this end the subject of the invention is a system for diagnosis of a driver as defined in Claim 1. Particular embodiments of the invention are defined in the sub-claims.

With the arrangement according to the invention, whenever an anomaly is detected, its presence is stored in a corresponding memory circuit, resetting the information of the memory circuits corresponding to other types of anomalies which may have been previously detected. Downstream of this memory circuit the system has a sequential logic network which therefore receives input information updated to the last detected anomaly. The sequential logic network is formed as a state machine and is adapted to code the operating state of the driver as a function of the detected anomalies. This state machine receives a number of logic input signals equal to the number of anomalies recognisable by the system, in addition to a system reset signal once reading by the control unit has taken place, and the driver control signal indicative of the current operating phase. This sequential network, as a function of the received input logic signals, achieves an internal state corresponding to an operating state of the driver. This sequential network makes available to the microprocessor or, more advantageously, to a serial interface circuit, a word of N bits on an output bus for the description of the detected operating state.

In particular, if n anomalies are to be detected and there are k possible operating phases of the driver, the state machine is advantageously implemented in such a way as to recognise n operating states corresponding to the presence of each anomaly, k operating states corresponding to the condition of "no detected anomaly in the current operating phase", and one operating state corresponding to the condition of "no detected anomaly in each operating phase".

For coding all the above-mentioned possibilities in a binary language, the state machine will have to have at its output an N bit word, with N such that:

$$2^N \geq n+k+1$$

The operation of the system is further improved by the use of an auxiliary driving module located in the path of the driver control signal leading to the driver itself. This module allows the driver to be disactivated as a consequence of the detection of an anomaly even in the operating phase in which this driver is controlled to be active by the control unit (ON phase), allowing its re-activation as soon as the control unit has read its operating state, with consequent resetting of the system. In addition, the auxiliary driving module is set up to disactivate the driver again if this is still controlled to be active, whenever the system detects that the anomaly remains.

Further advantages and characteristics of the present invention will become apparent from the following detailed description, given with reference to the attached drawings and provided purely by way of non-limitative example, in which:

Figure 1 is a block circuit diagram of the previously described prior art diagnosis system;

Figure 2 is a block circuit diagram of a diagnosis system according to the invention;

Figure 3 is a detailed circuit diagram of the sequential logic network of Figure 2; and

Figure 4 is a detailed circuit diagram of the auxiliary driving module of Figure 2.

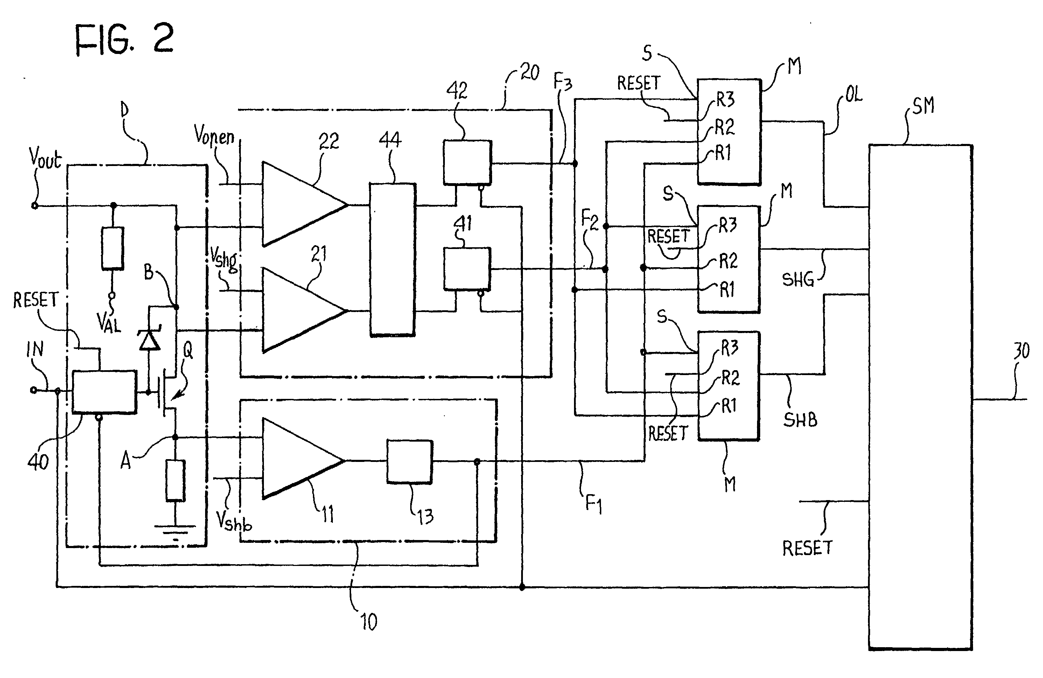

A diagnosis system according to the invention is described with reference to Figure 2, in which the same or identical elements to those already described with reference to the known prior art system are identified with the same alphanumeric references.

The driver is, by analogy with the example of Figure 1, of the so-called low-side type, for which the anomalies which it is desired to detect are short circuit to battery, short circuit to ground and open circuit to load. The following considerations can however be extended to other types of drivers and for a different number of possible anomalies.

The driver D includes an auxiliary driving module 40 which receives, at a first input, the control logic signal IN output by the microprocessor control unit. The circuit D is controlled in one of a plurality of possible operating phases in dependence on the conduction state of the electronic switch Q driven, at a control electrode, by the auxiliary driving module 40. In turn the driver D drives a corresponding actuator device (not shown) via a driving signal $V_{out}$ in a conventional manner.

A first node A and a second node B of the driver D are connected to the inputs of corresponding first and second comparator circuits, respectively indicated 10 and 20. The first comparator circuit 10 is arranged to recognise a short circuit to battery, and receives at its input a corresponding reference voltage $V_{shb}$. The second comparator circuit 20 is arranged to recognise a short circuit to ground and an open circuit to load, and receives corresponding input reference voltages $V_{shg}$ and $V_{open}$. These circuits provide at their outputs the overall diagnosis logic signals $F_1$, $F_2$, $F_3$ indicative of the presence/absence of the anomaly which they are appointed to recognise.

The comparator circuit 10 includes a threshold comparator 11 adapted to compare the voltage occurring at the node A with the short-circuit-to-battery reference voltage $V_{shb}$, and an analogue filter 13 arranged at the output of the threshold comparator. The diagnosis signal $F_1$ is provided from the output of the analogue filter and the whole comparator circuit 10.

The comparator circuit 20 includes two threshold comparators 21 and 22 adapted to compare the voltage at the node B and, respectively, the short-circuit-to-ground reference voltage $V_{shg}$ and the open-circuit-to-load reference voltage $V_{open}$. The outputs of the threshold comparators 21 and 22 are coupled to corresponding counters 41 and 42 via a decoder 44. These counters receive at respective reset inputs the control logic signal IN output by the microprocessor control unit. The diagnosis signals $F_2$ and $F_3$ are provided from the outputs of the counters 41 and 42 and the whole comparator circuit 20.

The diagnosis signals $F_1$, $F_2$, $F_3$ are supplied to the inputs of a plurality of memory circuits M, and in particular to a number of such circuits equal to the number of different anomalies which it is desired to detect. The memory circuits M each receive a respective signal $F_1$, $F_2$ or $F_3$ at their set input S, the other signals being addressed to corresponding reset inputs R1 and R2. These memory circuits are each provided with a third reset input R3 which can receive a memory reset signal RESET output by the microprocessor following a reading of the operating state of the driver D, via a serial peripheral interface SPI (not shown).

At the outputs of the memory circuits M appear respective first logic signals SHB, SHG, OL, indicative, in their active state, of the presence of the corresponding anomaly as the last anomaly occurred starting from a system reset operation.

The combination of the signals SHB, SHG, OL is provided to the inputs of a logic network of the sequential type such as a state machine SM, adapted also to receive the input logic control signal IN output by the control unit and the reset signal RESET. The state machine SM outputs a coded word of the detected operating state of the driver D on a three bit state bus 30. The state bus 30 is then connected to the input of the serial peripheral interface SPI, possibly arranged to receive at other inputs similar state buses coming from the state machines corresponding to other diagnosis systems integrated on the same semiconductor component. This interface can be selected by the microprocessor of the control unit and is adapted to transmit the detected information to it in a synchronised manner in a known way.

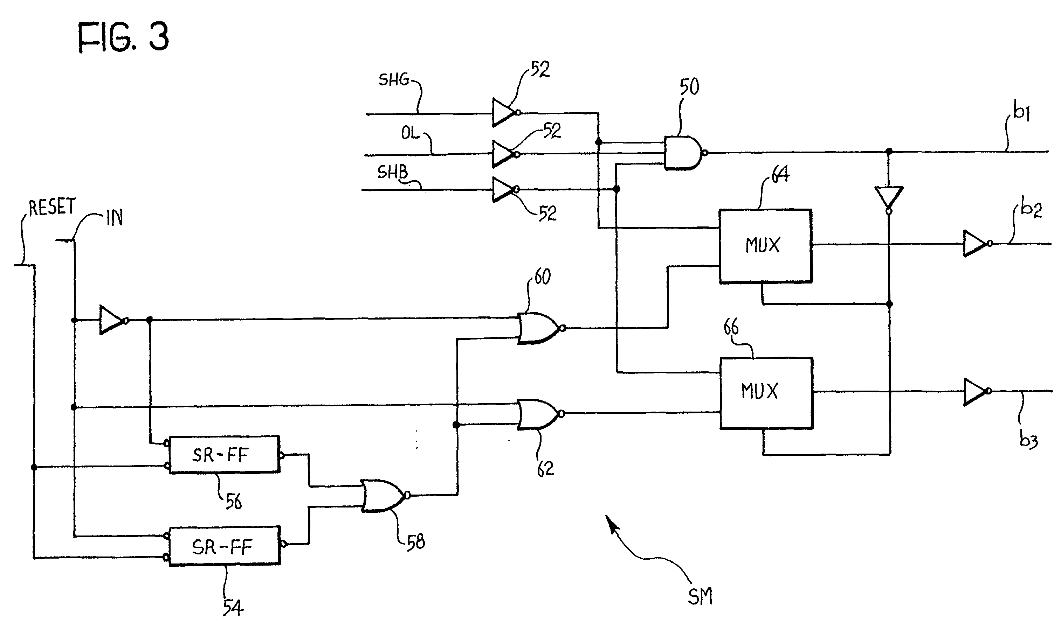

The state machine SM is described in detail with reference to Figure 3. The logic signals SHG, OL, SHB are provided to the input of a NAND gate 50 via respective inverter gates 52. The output signal from the NAND gate 50 is made available at a first output $b_1$ of the state machine SM as the first bit of the coded word. Two flip-flops 54, 56 of the set-reset type, advantageously formed in NAND logic, receive the control logic signal IN at a set input, as a direct signal and as an inverted signal respectively, and the reset signal RESET at a reset input. The outputs of both of the flip-flops 54, 56 are coupled together via a first NOR gate 58, and the logic signal thus obtained is supplied to the input of a pair of second NOR gates, 60, 62 respectively, which receive the control logic signal IN at a second input, respectively inverted and direct. The outputs of the second NOR gates 60, 62 are coupled to the inputs of corresponding two-way multiplexer circuits 64, 66 which receive the inverted signal SHG and the inverted signal SHB respectively at the other input, and are controlled at their selection inputs by signals derived from the signal made available at the first output $b_1$ of the state machine. The output signals from the multiplexers 64, 66 are made available, via associated inverters, at the outputs $b_2$ and $b_3$ of the state machine as the remaining bits of the coded word.

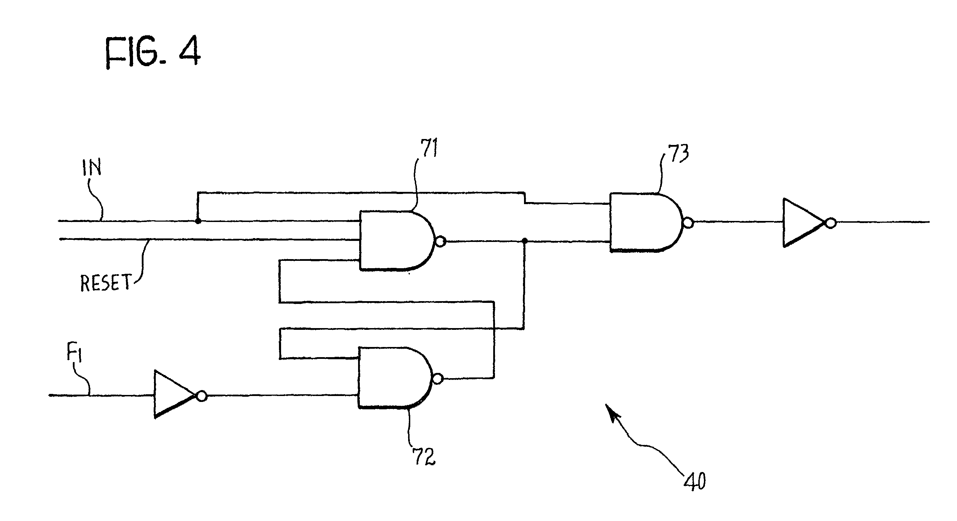

The auxiliary driving module 40 is described with reference to Figure 4. It comprises a pair of NAND gates 71, 72 connected together in the configuration of a set-reset flip-flop, the set input of which receives the logic control signal IN and the reset signal RESET AND- coupled together, and the reset input of which receives the signal $F_1$ output by the comparator circuit 10 and then inverted. The output of the first gate 71 is further coupled with the logic control signal IN via a third NAND gate 73 and provided to the output of the whole module 40 via an inverter.

In the preferred embodiment described, the first comparator circuit 10 is able to detect a short circuit to battery when the driver is active (operating phase ON, that is to say the switch Q is turned on), whilst the second comparator circuit 20 is able to detect a short circuit to ground and/or a condition of open circuit to load when the driver is disactivated (operating phase OFF, that is to say the switch Q is turned off).

Each time that the first or the second comparator circuit detects an anomaly during the operating phase of the driver in which they are active, they signal this condition by driving the corresponding signal $F_i$ (i = 1, 2, 3) to a high logic value (or low according to the logic convention used). This signal is provided to the set input S of the memory circuit M intended for storing the presence of this anomaly, whilst simultaneously it is provided to a reset input R1 or R2 of the remaining memory circuits in such a way as to reset the contents of such circuits and cancel any trace of the previously detected anomalies. In this way only the last anomaly which has occurred is stored. The memory circuits are moreover reset upon each reading by the control unit by means of the RESET signal.

The combination of signals SHG, OL, SHB output from the memory circuits conventionally provides information about the absence of anomalies (combination 0, 0, 0) or the identity of the last detected anomaly (a signal at high logic value). This combination of signals, provided to the input of the state machine SM together with information relating to the current operating phase of the driver D, determines, as a function of the current state of the machine, its subsequent state, which the machine will provide at its output converted into the corresponding coded word. The state machine SM is implemented in such a way as to output to the bus 30 a three bit word ($b_3$, $b_2$, $b_1$) which identifies all the possible combinations of operating states of the driver D in a unique manner as set out in the following table:

| $b_3$ | $b_2$ | $b_1$ | Significance |
|---|---|---|---|
| 0 | 0 | 1 | open circuit to load |
| 0 | 1 | 1 | short circuit to ground |
| 1 | 0 | 1 | short circuit to battery |
| 0 | 1 | 0 | no anomaly detected in the operating phase OFF |
| 1 | 0 | 0 | no anomaly detected in the operating phase ON |
| 1 | 1 | 0 | no anomaly detected in any operating phase |
| 1 | 1 | 1 | not used |
| 0 | 0 | 0 | not used |

In the preferred embodiment, the machine SM is arranged to signal the presence of an anomaly by driving the output $b_1$ at a high logic value and by coding the type of anomaly by means of the combination of the outputs $b_2$ and $b_3$. A signal SHG, OL or SHB which has a high logic value drives a signal of low logic value at a corresponding input of the NAND gate 50 because of the presence of the inverters 52 in the path. Since the inputs of a NAND gate are active for a low logic value, the condition in which at least one signal SHG, OL or SHB has a high logic value is sufficient to take the output $b_1$ also to a high logic value. At the same time, a low logic value is established at the selection input of the multiplexers 64, 66 and causes these latter to transmit the signals SHG and SHB to the ouputs $b_2$ and $b_3$.

If a short circuit to the battery is detected during the ON operating phase of the driver D, the auxiliary driving module 40 actively intervenes. When the anomaly is detected the signal $F_1$ assumes a high logic value and the module 40 outputs a signal such as to turn off the switch Q and disactivate the driver D. After the operating state of the circuit is read by the control unit upon the system reset command, that is to say when the RESET signal assumes a high logic value, the module 40 prepares itself to reactivate the driver D if it simultaneously receives a control logic signal IN such as to control the driver D to return to the ON operative phase. If the system detects that the anomaly remains, the module 40 again outputs a signal such as to turn off the switch Q and disactivate the driver D after a delay time interval determined by the presence of the analogue filter 13. However, if the anomaly is no longer present, the module 40 transmits the control logic signal IN directly from the control unit to the switch Q.

If no anomaly is detected the machine SM commands the output $b_1$ to a low logic value and, by combination of the outputs $b_2$ and $b_3$, produces three separate codes of an operating state which excludes the presence of anomalies, respectively distinguishing the cases in which, starting from the last reading by the control unit (high logic value of the RESET signal) no anomaly state is detected in the current operating phase (ON or OFF) or in both possible operating phases. The signals SHG, OL or SHB have a low logic value so that all the inputs of the NAND gate 50 receive a high logic value signal. In this condition the output $b_1$ has a low logic value and, at the same time, a high logic value is established at the selection input of the multiplexers 64, 66 making these latter transmit to the outputs $b_2$, $b_3$ the signals received by the circuit network portion arranged to recognise the operating phases which have occurred following a system reset command.

Naturally, the principle of the invention remaining the same, the embodiments and implementation details can be widely varied with respect to what has been described and illustrated purely by way of non-limitative example without by this departing from the protective scope of the present invention. For example, the embodiment described can be adapted for a diagnosis system of any other type of driver and for any number of operating states which it is intended to detect, simply by providing a number of memory circuits equal to the number of anomalies which it is intended to detect, and a state machine formed to translate a predetermined coding law in a logic circuit. A state machine of this type will have to be such as to have a sufficient number of inputs to receive a corresponding number of logic signals indicative of the anomalies encountered, and carrying information about the current operating phase of the driver D and activation of a memory circuit reset command, and a number of outputs such as to provide a sufficient number of combinations to represent the whole set of possible operating states.

**Claims**

1. A system for diagnosis of a driver (D), of the type adapted to detect one or more circuit anomalies capable of occurring in the said driver, including:

   - voltage comparator means (10, 20) for comparing at least one voltage present at a diagnosis node (A; B) of the said driver (D) with at least one corresponding reference voltage ($V_{shb}$; $V_{shg}$, $V_{open}$) and for generating diagnosis logic signals ($F_1$; $F_2$, $F_3$) each indicative of the existence of a corresponding type of anomaly; and
   - coding circuit means (M, SM) adapted to receive the said diagnosis signals ($F_1$, $F_2$, $F_3$) and to output information relating to an overall operating state of the driver, the said information being presented in a form capable of being recognised by a control unit of the driver (D),

   the system being **characterised in that** the coding circuit means (M, SM) include:

   - a first circuit portion for storing the said diagnosis signals ($F_1$, $F_2$, $F_3$), adapted to provide, at its outputs, first logic signals (SHB, SHG, OL) indicative of the last anomaly occurred after a system reset operation; and
   - a second circuit portion for coding the said first logic signals (SHB, SHG, OL) including a logic network (SM) of sequential type adapted to:

     receive at its inputs the first logic signals (SHB, SHG, OL) stored in the first circuit portion and at least one second logic signal (IN) indicative of the current operating phase of the driver (D);
     achieve, as a function of the said first and second logic signals (SHB, SHG, OL; IN) a stable internal state such as to determine output information in the form of an N bit coded word representative of an occurred anomaly, when at least one of the said first logic signals (SHB, SHG, OL) reaches a predetermined logic value indicative of the presence of an anomaly;
     achieve, as a function of the said first and second logic signals (SHB, SHG, OL; IN) a stable internal state such as to determine output information in the form of an N bit coded word representative of a condition of absence of anomalies in the current operating phase when none of the first logic signals (SHB, SHG, OL) reaches the said predetermined logic value indicative of the presence of an anomaly and this condition has not been checked, since a system reset operation, for each operating phase of the driver (D);
     achieve, as a function of the said first and second logic signals (SHB, SHG, OL; IN) a stable internal state such as to determine output information in the form of an N bit coded word representative of a condition of absence of anomalies in any operating phase when none of the first logic signals (SHB, SHG, OL) reaches the said predetermined logic value indicative of the presence of an anomaly and this condition has been checked, since a system reset operation, for any operating phase of the driver (D).

2. A system according to Claim 1, **characterised in that** the said first circuit portion includes a memory element (M) for each type of detectable circuit anomaly, the said memory element (M) having a set input (S) adapted to receive a diagnosis signal indicative of the existence of the corresponding type of anomaly, and reset inputs (R1, R2, R3) adapted to receive the remaining diagnosis signals and at least a third logic signal (RESET) indicative of a system reset operation.

3. A system according to Claim 1 or Claim 2, **characterised in that** the said sequential logic network (SM) includes:

- a first portion (50, 52) for processing the said first logic signals (SHB, SHG, OL), the said first portion providing at its output a signal corresponding to a first bit ($b_1$) of the coded word;
- a second portion (54, 56, 58, 60, 62) for processing the said second (IN) and third (RESET) logic signals; and
- at least one multiplexer device (64, 66) having a first input coupled to one of the said first logic signals (SHB, SHG, OL) and a second input coupled to the said second portion (54, 56, 58, 60, 62), the said at least one multiplexer device (64, 66) being driven at a selection input via a signal derived by the output ($b_1$) of the said first portion (50, 52) of the sequential network, the output of the multiplexer device (64, 66) being made available in correspondence with a remaining bit ($b_2$; $b_3$) of the coded word.

4. A system according to Claim 3, **characterised in that** the said first portion of the sequential network (SM) includes a plurality of inverting gates (52) each arranged to receive at its input a respective first logic signal (SHB, SHG, OL), the said inverting gates (52) being coupled at their inputs to a NAND gate (50), the output of which provides the said first bit ($b_1$) of the coded word.

5. A system according to Claim 3, **characterised in that** the said second portion of the sequential network (SM) includes bistable circuits (54, 56) adapted to receive the said second logic signals (IN) at a set input and the said third logic signals (RESET) at a reset input, the outputs of which bistable circuits are combined via a first NOR gate (58) and provided to a first input of at least one second NOR gate (60, 62) the second input of which is coupled to the said second logic signals (IN), the second NOR gates (60, 62) corresponding in number to the possible number of operating phases of the driver (D),
and **in that** the said at least one multiplexer device (64, 66) has its second input coupled to an output of a corresponding second NOR gate (60, 62).

6. A system according to any preceding claim, **characterised in that** the number N of bits of the said coded word is calculated as a function of the number n of detectable anomalies and the number k of possible operating phases of the driver (D) according to the formula:

$$2^N \geq n+k+1$$

7. A system according to any preceding claim, **characterised in that** it includes an auxiliary driving module (40) coupled to the input of the driver (D) and having a plurality of inputs adapted to receive, respectively, second (IN) and third (RESET) logic signals and diagnosis logic signals ($F_1$) indicative of the existence of an anomaly detectable in the operating phase of activation of the driver (D),
the said driving module (40) being arranged to:

- disactivate the driver (D) as a consequence of the detection of an anomaly in the operating phase in which this driver is active;
- allow its re-activation following a system reset operation; and
- again disactivate the driver (D) if the system detects that the anomaly remains in the same operating phase.

8. A system according to Claim 7, **characterised in that** the said auxiliary driving module (40) includes a combination of NAND gates (71, 72) in the form of a bistable circuit the set input of which is adapted to receive second and third logic signals (IN, RESET) AND-coupled together and the reset input of which is adapted to receive a signal correlated to at least one diagnosis logic signal ($F_1$) indicative of the existence of an anomaly detectable in the operating phase of activation of the driver (D),
the output of the said combination of the logic gates (71, 72) being coupled to the said second logic signals (IN) via a NAND gate (73) in such a way as to generate an output signal from the whole auxiliary driving module (40).

**EP 1 052 518 B1**

**Patentansprüche**

1. System zur Diagnose eines Treibers (D) vom Typ, der dazu angepasst ist, eine oder mehrere Schaltungsanomalien, die im Treiber auftreten können, zu detektieren, umfassend:

   - Spannungsvergleichsmittel (10, 20) zum Vergleichen zumindest einer an einem Diagnoseknoten (A; B) des Treibers (D) vorhandenen Spannung mit zumindest einer entsprechenden Referenzspannung ($V_{shb}$; $V_{shg}$, $V_{open}$) und zum Erzeugen logischer Diagnosesignale ($F_1$; $F_2$, $F_3$), von welchen jedes die Existenz eines entsprechenden Anomalietyps anzeigt; und
   - Codierschaltungsmittel (M, SM), die zum Empfang der Diagnosesignale ($F_1$, $F_2$, $F_3$) und zur Ausgabe von Informationen bezüglich eines Gesamtbetriebszustands des Treibers angepasst sind, wobei diese Informationen in einer Form präsentiert werden, die von einer Steuereinheit des Treibers (D) erkannt werden kann,

   wobei das System **dadurch gekennzeichnet ist, dass** die Codierschaltungsmittel (M, SM) Folgendes umfassen:

   - einen ersten Schaltungsabschnitt zum Speichern der Diagnosesignale ($F_1$, $F_2$, $F_3$), welcher dazu angepasst ist, an seinen Ausgängen erste logische Signale (SHB, SHG, OL), welche die letzte, nach einer System-Rücksetzungsoperation aufgetretene Anomalie anzeigen, bereitzustellen; und
   - einen zweiten Schaltungsabschnitt zum Codieren der ersten logischen Signale (SHB, SHG, OL) mit einem logischen Netzwerk (SM) vom sequentiellen Typ, welches dazu angepasst ist:

     an seinen Eingängen die im ersten Schaltungsabschnitt gespeicherten, ersten logischen Signale (SHB, SHG, OL) und zumindest ein die laufende Betriebsphase des Treibers (D) anzeigendes, zweites logisches Signal (IN) zu empfangen;
     als Funktion der ersten und zweiten logischen Signale (SHB, SHG, OL; IN) einen stabilen internen Zustand zu erzielen, um Ausgangsinformationen in Form eines N-Bitcodierten Worts zu bestimmen, das eine aufgetretene Anomalie darstellt, wenn zumindest eines der ersten logischen Signale (SHB, SHG, OL) einen das Vorhandensein einer Anomalie anzeigenden, vorbestimmten logischen Wert erreicht;
     als Funktion der ersten und zweiten logischen Signale (SHB, SHG, OL; IN) einen stabilen internen Zustand zu erzielen, um Ausgangsinformationen in Form eines N-Bitcodierten Worts zu bestimmen, das einen Zustand des Fehlens von Anomalien in der laufenden Betriebsphase darstellt, wenn keines der ersten logischen Signale (SHB, SHG, OL) den das Vorhandensein einer Anomalie anzeigenden, vorbestimmten logischen Wert erreicht und dieser Zustand seit einer System-Rücksetzungsoperation nicht für jede Betriebsphase des Treibers (D) überprüft wurde;
     als Funktion der ersten und zweiten logischen Signale (SHB, SHG, OL; IN) einen stabilen internen Zustand zu erzielen, um Ausgangsinformationen in Form eines N-Bitcodierten Worts zu bestimmen, das einen Zustand des Fehlens von Anomalien in irgendeiner Betriebsphase darstellt, wenn keines der ersten logischen Signale (SHB, SHG, OL) den das Vorhandensein einer Anomalie anzeigenden, vorbestimmten logischen Wert erreicht und dieser Zustand seit einer System-Rücksetzungsoperation für irgendeine Betriebsphase des Treibers (D) überprüft wurde.

2. System gemäß Anspruch 1, **dadurch gekennzeichnet, dass** der erste Schaltungsabschnitt ein Speicherelement (M) für jeden Typus einer detektierbaren Schaltanomalie umfasst, wobei dieses Speicherelement (M) einen Setz-Eingang (S) besitzt, der zum Empfang eines die Existenz des entsprechenden Anomalietyps anzeigenden Diagnosesignals angepasst ist, sowie Rücksetzeingänge (R1, R2, R3), die zum Empfang der verbleibenden Diagnosesignale und zumindest eines eine System-Rücksetzungsoperation anzeigenden, dritten logischen Signals (RESET) angepasst sind.

3. System gemäß Anspruch 1 oder Anspruch 2, **dadurch gekennzeichnet, dass** das sequentielle logische Netzwerk (SM) Folgendes umfasst:

   - einen ersten Abschnitt (50, 52) zur Verarbeitung der ersten logischen Signale (SHB, SHG, OL), wobei der erste Abschnitt an seinem Ausgang ein Signal bereitstellt, das einem ersten Bit ($b_1$) des codierten Worts entspricht;
   - einen zweiten Abschnitt (54, 56, 58, 60, 62) zur Verarbeitung der zweiten (IN) und dritten (RESET) logischen Signale; und
   - zumindest eine Multiplexer-Vorrichtung (64, 66) mit einem an eines der ersten logischen Signale (SHB, SHG, OL) gekoppelten, ersten Eingang und einem an den zweiten Abschnitt (54, 56, 58, 60, 62) gekoppelten, zweiten Eingang, wobei die zumindest eine Multiplexer-Vorrichtung (64, 66) über ein vom Ausgang ($b_1$) des ersten Abschnitts (50, 52) des sequentiellen Netzwerks abgeleitetes Signal an einem Auswahleingang angetrieben wird, wobei der Ausgang der Multiplexer-Vorrichtung (64, 66) in Übereinstimmung mit einem verbleibenden Bit ($b_2$; $b_3$) des codierten Worts verfügbar gemacht wird.

4. System gemäß Anspruch 3, **dadurch gekennzeichnet, dass** der erste Abschnitt des sequentiellen Netzwerks (SM) eine Mehrzahl von invertierenden Gates (52) umfasst, von welchen jedes zum Empfang eines jeweiligen ersten logischen Signals (SHB, SHG, OL) an seinem Eingang angeordnet ist, wobei die invertierenden Gates (52) an ihren Eingängen an ein NAND-Gate (50), dessen Ausgang das erste Bit ($b_1$) des codierten Worts bereitstellt, gekoppelt sind.

5. System gemäß Anspruch 3, **dadurch gekennzeichnet, dass** der zweite Abschnitt des sequentiellen Netzwerks (SM) bistabile Schaltungen (54, 56) umfasst, welche zum Empfang der zweiten logischen Signale (IN) an einem Setz-Eingang und der dritten logischen Signale (RESET) an einem Rücksetzeingang angepasst sind und deren Ausgänge über ein erstes NOR-Gate (58) kombiniert sind und einem ersten Eingang zumindest eines zweiten NOR-Gates (60, 62) zugeführt werden, dessen zweiter Eingang an die zweiten logischen Signale (IN) gekoppelt ist, wobei die zweiten NOR-Gates (60, 62) der Anzahl nach der möglichen Anzahl von Betriebsphasen des Treibers (D) entsprechen,

und dass die zumindest eine Multiplexer-Vorrichtung (64, 66) mit ihrem zweiten Eingang an einen Ausgang eines entsprechenden zweiten NOR-Gates (60, 62) gekoppelt ist.

6. System gemäß einem der vorhergehenden Ansprüche, **dadurch gekennzeichnet, dass** die Bitanzahl N des codierten Worts als Funktion der Anzahl n an detektierbaren Anomalien und der Anzahl k an möglichen Betriebsphasen des Treibers (D) berechnet wird, und zwar gemäß der Formel:

$$2^N \geq n+k+1$$

7. System gemäß einem der vorhergehenden Ansprüche, **dadurch gekennzeichnet, dass** es ein Hilfssteuermodul (40) umfasst, welches an den Eingang des Treibers (D) gekoppelt ist und eine Mehrzahl von Eingängen besitzt, die zum Empfang zweiter (IN) und dritter (RESET) logischer Signale bzw. logischer Diagnosesignale ($F_1$), welche die Existenz einer in der Betriebsphase der Aktivierung des Treibers (D) detektierbaren Anomalie anzeigen, angepasst sind,

wobei das Ansteuermodul (40) dazu angeordnet ist:

- den Treiber (D) als Folge der Detektion einer Anomalie in der Betriebsphase, in welcher dieser Treiber aktiv ist, zu deaktivieren;
- nach einer System-Rücksetzungsoperation seine Reaktivierung zu erlauben; und
- den Treiber (D) abermals zu deaktivieren, wenn das System ein Fortbestehen der Anomalie in derselben Betriebsphase detektiert.

8. System gemäß Anspruch 7, **dadurch gekennzeichnet, dass** das Hilfsansteuermodul (40) eine Kombination von NAND-Gates (71, 72) in Form einer bistabilen Schaltung umfasst, deren Setz-Eingang zum Empfang zweiter und dritter, miteinander AND-verknüpfter logischer Signale (IN, RESET) angepasst ist und deren Rücksetzeingang zum Empfang eines Signals angepasst ist, welches mit zumindest einem logischen Diagnosesignal ($F_1$), das die Existenz einer in der Betriebsphase der Aktivierung des Treibers (D) detektierbaren Anomalie anzeigt, in einer Wechselbeziehung steht,

wobei der Ausgang dieser Kombination der logischen Gates (71, 72) über ein NAND-Gate (73) solcherart an die zweiten logischen Signale (IN) gekoppelt ist, dass ein Ausgangssignal vom gesamten Hilfsansteuermodul (40) erzeugt wird.

**Revendications**

1. Système de diagnostic d'un circuit d'attaque (D), du type adapté pour détecter une ou plusieurs anomalies de circuit susceptibles de se produire dans ledit circuit d'attaque, le système comprenant :

- des moyens de comparaison de tension (10, 20) adaptés pour comparer au moins une tension présente au niveau d'un noeud de diagnostic (A ; B) dudit circuit d'attaque (D) avec au moins une tension de référence ($V_{shb}$ ; $V_{shg}$, $V_{open}$) correspondante, et adaptés pour produire des signaux de diagnostic logiques (F1, F2, F3), chaque signal indiquant l'existence d'un type d'anomalie correspondant ; et

- des moyens de circuit de codage (M, SM) adaptés pour recevoir lesdits signaux de diagnostic ($F_1$, $F_2$, $F_3$) et pour émettre des informations relatives à un état de fonctionnement global du circuit d'attaque, lesdites informations étant présentées sous une forme susceptible d'être reconnue par un module de contrôle du circuit d'attaque (D),

le système étant **caractérisé en ce que** les moyens de circuit de codage (M, SM) comprennent :

- une première portion de circuit destinée au stockage desdits signaux de diagnostic (F1, F2, F3), adaptée pour fournir, en sortie, des premiers signaux logiques (SHB, SHG, OL) indiquant la dernière anomalie qui s'est produite consécutivement à une opération de réinitialisation du système ; et

- une deuxième portion de circuit destinée au codage desdits premiers signaux logiques (SHB, SHG, OL) comprenant un réseau de circuits logiques (SM) du type séquentiel, adaptée pour :

recevoir, en entrée, les premiers signaux logiques (SHB, SHG, OL) stockés dans la première portion de circuit, et au moins un deuxième signal logique (IN) indiquant la phase de fonctionnement électrique du circuit d'attaque (D) ;

parvenir à atteindre, en tant qu'une fonction desdits premiers et deuxièmes signaux logiques (SHB, SHG, OL ; IN) un état interne stable tel qu'il lui permette de déterminer des informations de sortie, sous la forme d'un mot codé de N bits, représentatif d'une anomalie qui s'est produite, lorsque au moins un desdits premiers signaux logiques (SHB, SHG, OL) atteint une valeur logique prédéterminée indiquant la présence d'une anomalie ;

parvenir à atteindre, en tant qu'une fonction desdits premiers et deuxièmes signaux logiques (SHB, SHG, OL ; IN) un état interne stable tel qu'il lui permette de déterminer des informations de sortie, sous la forme d'un mot codé de N bits, représentatif d'une condition d'absence d'anomalies dans la phase de fonctionnement en cours, lorsque aucun des premiers signaux logiques (SHB, SHG, OL) n'atteint ladite valeur logique prédéterminée indiquant la présence d'une anomalie et que cette condition n'a pas été vérifiée, depuis une opération de réinitialisation du système, pour chacune des phases de fonctionnement du circuit d'attaque (D) ;

parvenir à atteindre, en tant qu'une fonction desdits premiers et deuxièmes signaux logiques (SHB, SHG, OL ; IN) un état interne stable tel qu'il lui permette de déterminer des informations de sortie, sous la forme d'un mot codé de N bits, représentatif d'une condition d'absence d'anomalies dans l'une quelconque des phases de fonctionnement, lorsque aucun des premiers signaux logiques (SHB, SHG, OL) n'atteint ladite valeur logique prédéterminée indiquant la présence d'une anomalie et que cette condition n'a pas été vérifiée, depuis une opération de réinitialisation du système, pour l'une quelconque des phases de fonctionnement du circuit d'attaque (D).

2. Système selon la revendication 1, **caractérisé en ce que** ladite première portion de circuit comprend un organe de mémoire (M) pour chaque type d'anomalie de circuit détectable, ledit organe de mémoire (M) ayant une entrée programmée (S), adaptée pour recevoir un signal de diagnostic indiquant l'existence du type d'anomalie correspondant, et des entrées de réinitialisation (R1, R2, R3) adaptées pour recevoir les signaux de diagnostic restants et au moins un troisième signal logique (RESET) indiquant une opération de réinitialisation du système.

3. Système selon la revendication 1 ou la revendication 2, **caractérisé en ce que** ledit réseau de circuits logiques séquentiel (SM) comprend :

- une première portion (50, 52) destinée au traitement desdits premiers signaux logiques (SHB, SHG, OL), ladite première portion fournissant, en sortie, un signal correspondant à un premier bit ($b_1$) du mot codé ;

- une deuxième portion (54, 56, 58, 60, 62) destinée au traitement desdits deuxièmes (IN) et troisièmes (RESET) signaux logiques ; et

- au moins un dispositif de multiplexage (64, 66) possédant une première entrée couplée à l'un desdits premiers signaux logiques (SHB, SHG, OL) et une deuxième entrée couplée à ladite deuxième portion (54, 56, 58, 60, 62), ledit au moins un dispositif de multiplexage (64, 66) étant entraîné à une entrée de sélection par l'intermédiaire d'un signal dérivé par la sortie ($b_1$) de ladite première portion (50, 52) du réseau séquentiel, la sortie du dispositif de multiplexage (64, 66) étant rendue disponible en correspondance avec un bit restant ($b_2$ ; $b_3$)

du mot codé.

**4.** Système selon la revendication 3, **caractérisé en ce que** ladite première portion du réseau séquentiel (SM) comprend une pluralité de portes d'inversion (52) configurées chacune pour recevoir, en entrée, un premier signal logique respectif (SHB, SHG, OL), lesdites portes d'inversion (52) étant couplées au niveau de leurs entrées à une porte NON-ET (50), dont la sortie fournit ledit premier bit ($b_1$) du mot codé.

**5.** Système selon la revendication 3, **caractérisé en ce que** ladite deuxième portion du réseau séquentiel (SM) comprend des circuits bistables à déclencheur (54, 56) adaptés pour recevoir lesdits deuxièmes signaux logiques (IN) au niveau d'une entrée programmée et lesdits troisièmes signaux logiques (RESET) au niveau d'une entrée de réinitialisation, les sorties de ces circuits bistables à déclencheur étant combinées par l'intermédiaire d'une première porte NON-OU (58) et étant fournies à une première entrée d'au moins une deuxième porte NON-OU (60, 62), et dont la deuxième entrée est couplée aux dits deuxièmes signaux logiques (IN), les deuxièmes portes NON-OU (60, 62) correspondant, dans leur nombre, au nombre de phases de fonctionnement possibles du circuit d'attaque (D),
et **caractérisé en ce que** ledit au moins un dispositif de multiplexage (64, 66) a une deuxième entrée couplée à une sortie d'une deuxième porte NON-OU (60, 62) correspondante.

**6.** Système selon l'une quelconque des revendications précédentes, **caractérisé en ce que** le nombre N de bits dudit mot codé est calculé en tant qu'une fonction du nombre n d'anomalies détectables et du nombre k de phases de fonctionnement possibles du circuit d'attaque (D) selon la formule suivante :

$$2^N \geq n+k+1$$

**7.** Système selon l'une quelconque des revendications précédentes, **caractérisé en ce qu'**il comprend un module d'entraînement auxiliaire (40) couplé à l'entrée du circuit d'attaque (D) et ayant une pluralité d'entrées adaptées pour recevoir, respectivement, les deuxièmes (IN) et troisièmes (RESET) signaux logiques et les signaux de diagnostic logiques ($F_1$) indiquant l'existence d'une anomalie détectable dans la phase de fonctionnement active du circuit d'attaque (D),
ledit module d'entraînement (40) étant configuré de manière à :

- désactiver le circuit d'attaque (D) consécutivement à la détection d'une anomalie dans la phase de fonctionnement dans laquelle ce circuit d'attaque est actif ;
- autoriser sa remise en activité consécutivement à une opération de réinitialisation du système ; et
- désactiver à nouveau le circuit d'attaque (D) si le système vient à détecter que l'anomalie est toujours présente dans la même phase de fonctionnement.

**8.** Système selon la revendication 7, **caractérisé en ce que** ledit module d'entraînement auxiliaire (40) comprend une combinaison de portes NON-ET (71, 72) sous la forme d'un circuit bistable à déclencheur dont l'entrée programmée est adaptée pour recevoir les deuxièmes et troisièmes signaux logiques (IN, RESET) ET-couplés ensemble, et dont l'entrée de réinitialisation est adaptée pour recevoir un signal corrélé au niveau d'au moins un signal de diagnostic logique ($F_1$) indiquant l'existence d'une anomalie détectable dans la phase de fonctionnement active du circuit d'attaque (D),
la sortie de ladite combinaison de portes logiques (71, 72) étant couplée aux dits deuxièmes signaux logiques (IN) par l'intermédiaire d'une porte NON-ET (73) de manière à ce qu'un signal de sortie soit produit à partir du module d'entraînement auxiliaire (40) dans son ensemble.

FIG. 1

EP 1 052 518 B1

FIG. 2

EP 1 052 518 B1

FIG. 3

FIG. 4